# EUROPEAN PATENT APPLICATION

(11) **EP 2 613 143 A1**
(43) Date of publication of application: **10.07.2013**
(21) Application number: 12150392.4
(22) Date of filing: 06.01.2012
(51) Int. Cl.: G01N 27/84

(54) **Apparatus and method for non-destructive inspections**

(71) Applicant: Alstom Technology Ltd, 5400 Baden (CH)
(72) Inventor: Moser, Roland Richard, 8005 Zürich (CH); Peralta, Andres, 5405 Baden-Dättwil (CH); Dos Santos Silverio, Fernando Manuel, 5430 Wettingen (CH); Schoeneich, Patrick, 1817 Brent (CH); Mondada, Francesco, 1030 Bussigny (CH); Rochat, Frédéric, 1676 Chavannes-les-Forts (CH)

(57) **Abstract**

An apparatus and a method are provided for the inspection of ferromagnetic components using magnetic particles, particularly for in-situ inspection of parts of power plants, with the apparatus including a movable chassis defining a magnetic yoke with a central opening over a surface of the component to be inspected and a discharge nozzle to inject the magnetic particles onto the surface, a magnetic field source for generating a magnetic field on at least part of the surface below the opening and a probe to measure a representation of the spatial distribution of the magnetic particles on the surface.

## Description

The present invention relates to devices and methods for inspecting metal components and installation such as parts of large power generating plants, such as turbine blades, turbine rotors, electro-magnetic generators, boilers and pipes.

### Background

The in-situ or site inspection of turbine components by means of nondestructive methods (NDT) is a service which is typically carried out at intervals, in accordance to scheduled outages. In order to get access to the components of interest, many inspections require the dismantling of components resulting in lengthy and costly operations.

For NDT applications, the selection of the testing method and technique to use depends on the type of defects to be detected, the state of the part and its geometry. There are cases where the metallurgical characteristics of the components, their surface conditions, or the access to the area of inspection, limit the use of the available inspection technologies, requiring further disassembly or even the removal of the components from site.

For ferromagnetic components there are only a few NDT methods commonly used for the detection of defects exposed at the surface, such as cracks, holes, fissures and the like. They include the testing with eddy currents, ultrasonic probes or by Magnetic Particle Inspection (MPI).

Typically, the methods based on eddy currents use a small coil for scanning the inspection area within a band of three to five millimeter width. This relatively small area of sensitivity of a single sensor device results in time consuming routines when the inspection is performed manually. Though larger probes with multiple coils are available, they tend to be heavy and expensive and hence not easy to move and to use for site inspections. Further, the eddy currents are changed by the roughness and the geometry of the surface effectively reducing the sensitivity of the method for complex shaped components or for surfaces exposed to corrosion or erosion as many parts of a turbine.

Another well-known method is the inspection with ultrasonic waves. The waves are generated using transducers and are projected into the component to be inspected. Surface and subsurface discontinuities in the material scatter or reflect the ultrasonic wave. The transducers can detect the scattered or reflected signal and determine the location and shape of the discontinuity.

Metal Particle Inspection (MPI) on the other hand is used to detect surface and subsurface discontinuities in ferromagnetic materials such as iron, nickel, cobalt, and some of their alloys. The process injects a magnetic field into the part. The piece can be magnetized by direct or indirect magnetization. Direct magnetization occurs when the electric current is passed through the test object and a magnetic field is formed in the material. Indirect magnetization occurs when no electric current is passed through the test object, but a magnetic field is applied from an outside source. Small magnetic particles are spread in a dry or wet environment across the surface of the component to be inspected and attracted to areas around cracks and other surface defects as the the magnetic field becomes inhomogeneous at these defects. After a part has been magnetized, it is often required to be demagnetized again before use. This and other requirements for MPI methods and equipment are subject of several national and international standards, including for example the ASTM E 1444-05 standard.

In some variants of MPI, a special illumination of the surface is used to cause fluorescence of the particles to increase visibility and hence the sensitivity of the method.

Conventional MPI tools are commonly wet horizontal machines with large coils. Handheld devices using a simple yoke are also known. Both types of known instruments are either impossible or difficult to use for power plant inspection, if, for example, the turbine blades are kept in the rotor or if the stator of the turbine is closed.

General inspection tools and methods for various purposes of relevance to the present invention can be found for example in the United States patents 6316845, 7624827 and 7958955 and the published U.S applications 20080289421, 20090314089 and 20110174565.

Specific MPI inspection tools are described in the United States patent nos. 4950989 and 6316845 providing further background information relevant to the implementation of magnets, electromagnetic coils, yokes and magnetic particles.

Magnetic switchable devices are described in several publications including F. Rochat, P. Schoeneich, M. Bonani, S. Magnenat, F. Mondada, H. Bleuler, and H. Christoph "Design of Magnetic Switchable Device (MSD) and applications in climbing robot" in: H. Fujimoto, M. O. Tokhi, H. Mochiyama, and G. S. Virk, editors, Emerging Trends in Mobile Robotics, pages 375-382, Nagoya, 2010. World Scientific.

In light of the known prior art, the present invention can be regarded as addressing problems relating to mobility, size and general improvement of the applicability of MPI tools and methods, particularly in the field of on-site and in-situ inspections of parts of power generation plants, turbines, boilers, pipes and similar devices.

### Summary

According to an aspect of the present invention, there is provided an apparatus for the inspection of ferromagnetic components using magnetic particles, particularly for in-situ inspection of parts of power plants, with the apparatus including a movable chassis defining a magnetic yoke with a central opening over a surface of the component to be inspected and a discharge nozzle to inject the magnetic particles onto the surface, a magnetic field source for generating a magnetic field on at least part of the surface below the opening and a probe to measure a representation of the spatial distribution of the magnetic particles on the surface.

At least part of the chassis is advantageously made of ferromagnetic material in a ring-like shape with a central opening. This design can be seen as forming a yoke in a plane essentially parallel to the surface. The ring includes extensions of ferromagnetic material extending out of the plane of the ring in direction of the surface to be inspected. The extension are preferably designed such that the gap between the ring and the surface is reduced locally to less than 5 mm, more preferable less than 2 mm and even more preferably less than 1 mm. In a variant the gap width can be controlled by lowering or raising the chassis using for example screws or other adjustment devices.

For mobility the chassis can be mounted for example on three or more rolling elements such as rolls, wheels, spheres or on gliding elements such as skates.

The overall dimensions of the device are suitable for use as a mobile device and preferably as a handheld device. To improve the mobility, the longest horizontal dimension is preferably less than 200 mm. Its height is preferably less than 100 mm. Its weight is preferably less than 5 kg.

The discharge opening to inject the magnetic particles includes for example a nozzle attached to a reservoir of magnetic particles. This reservoir can be mounted on the chassis or, alternatively, it can be separated from the chassis. In the latter case, a tube connects the discharge opening with the remote reservoir.

A preferred embodiment of the magnetic field source for generating a magnetic field includes at least two rotatably mounted magnets mounted onto or within the ring-shaped frame, preferably at juxtaposed positions across the opening of the frame. With the magnets in place, the ferromagnetic frame forms a continuous yoke without a gap and with a central opening. A preferred variant includes two pairs magnets mounted such that one magnet of each pair can be actively rotated with the frame either manually or be motor means while the other magnet of each pair can follow the rotation. The magnets can be permanent magnets or include electromagnetic coils.

In a preferred embodiment of the invention, magnetization and demagnetization is achieved through rotation of one or more magnets, preferably in a sequence of rotations with decreasing amplitude of the rotating angles.

A preferred embodiment of the probe to measure a representation of spatial distribution includes an optical detector such as a camera for recording images of the surface under inspection.

In a variant of this preferred embodiment the probe to measure a representation of spatial distribution includes further a high intensity source of radiation, preferably electromagnetic radiation. This source can be for example a light emitting diode emitting ultraviolet (UV) light.

The chassis can further include a sensor which is capable of measuring location information or derivatives of location information such as velocity and direction to determine an absolute or relative position of the apparatus on the surface.

According to another aspect of the invention there is provided a method for inspecting of ferromagnetic components using magnetic particles, particularly for in-situ inspection of parts of power plants such as airfoils of a turbine being mounted onto a rotor, the method including the step of placing onto the airfoil an apparatus for the inspection of ferromagnetic components using magnetic particles with the apparatus comprising a movable chassis defining a magnetic yoke with a central opening over a surface of the component to be inspected and a discharge nozzle to inject the magnetic particles onto the surface, a magnetic field source for generating a magnetic field on at least part of the surface below the opening and a probe to measure a representation of the spatial distribution of the magnetic particles on the surface and measuring a representation of the spatial distribution of the magnetic particles on the surface.

In a preferred variant of this aspect of the invention, the magnetic field is switched between a state where a significant part of the field is directed into the surface through out-of-plane extensions of a ring-shaped frame of ferromagnetic material and a state where at least most of the field is confined within the ring-shaped frame without entering the surface.

These and further aspects of the invention will be apparent from the following detailed description and drawings as listed below.

### Brief Description of the Drawings

Exemplary embodiments of the invention will now be described, with reference to the accompanying drawings, in which:
- FIGs. 1A and 1B: show a magnetic switchable device for use in an inspection tool in accordance with an example of the invention;
- FIG. 2: shows another magnetic switchable device for use in an inspection tool in accordance with an example of the invention;
- FIGs. 3A-3C: illustrate a demagnetization process in accordance with an example of the invention; and
- FIG. 4: illustrates the arrangement of elements in an inspection tool in accordance with an example of the invention.

### Detailed Description

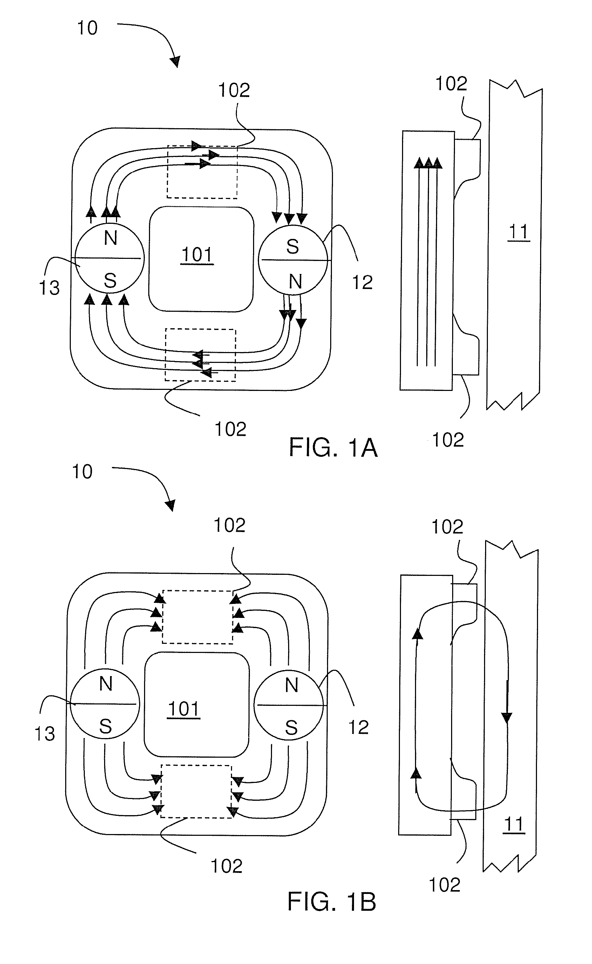

Aspects and details of examples of the present invention are described in further details in the following description. The operating principles on which the following examples of the invention are based are first illustrated making reference to FIG. 1A - 1B. The figures show views of the top and the side of a frame structure and magnets as can applied in the examples.

In FIG. 1 A there is shown a ring-shaped frame **10** of ferromagnetic material. The thickness of the frame is 6 mm and its width is 45 mm and length 40 mm. The frame **10** has an approximately square opening **101** of 20 mm width and length. The frame has extensions **102** of ferromagnetic material in direction of a surface **11** to be inspected. The height of the extension is about 10 mm giving the top of the frame a 16.5 mm clearance to the surface **11.** The gap between the bottom face of the extensions **102** and the surface **11** can be adjusted within the range of 0 or 0.1 mm to 4 mm.

Also embedded into the frame are two disk-shaped permanent magnets **12, 13** with a diameter of 10 mm diameter and a height of 6 mm. One magnet **12** carries a fin (not shown) which couples the magnet to a micromotor (not shown). The micromotor can rotate the magnet **12** within the ferromagnetic frame **10.** The other magnet **13** is similarly mounted within the frame.

The magnets **12, 13** are arranged to form a magnetic switchable device which can be switched between a first state and a second state as is illustrated in the FIGs. 1 A and 1 B respectively. In the first state the poles of the magnets are rotated relatively to each other such that the magnetic field as indicated by arrows remains within the frame **10** which acts a yoke. In this state none or minimal parts of the magnetic field are directed into the ferromagnetic surface **11.** In the second state the orientation of the poles is changed such that the magnetic field is at least partly directed into the extensions **102** and through the extensions into the surface **11** providing a magnetization of the surface within the area between the extensions, i.e. the area beneath the opening.

By rotating both magnets **12, 13,** the orientation of the north and south pole of the magnet can be interchanged, resulting in a magnetic field having a direction in the surface **11** opposite to the direction shown in Fig. 1 B. This switch of direction can be used for demagnetizing the surface in a manner described in more detail below

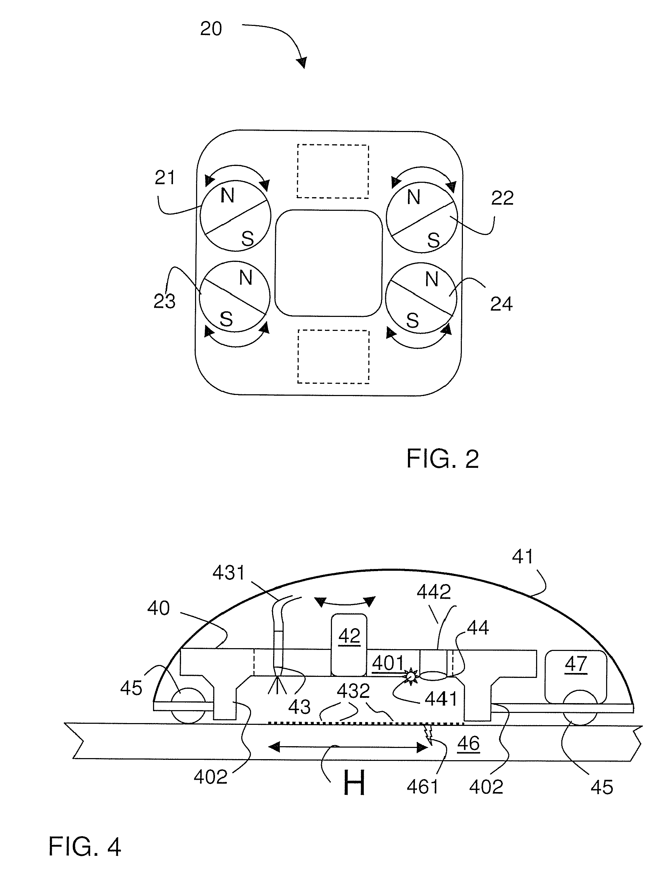

The operating principles illustrated in FIGs. 1A and 1 B can be extended to more than two magnets. An example with four magnets is shown in FIG. 2 adding strength and more control options to the switching process. In the example of FIG. 2, two magnets **21, 22** are designed to be rotated actively using motors, while two magnets **23, 24** are mounted such that they are capable of rotating within the frame **20.** The rotation of one magnet of a pair **21, 23, 22, 24** is sufficient to cause a rotation of the paired magnet, hence it is not always necessary to provide all magnets of a pair with a rotating motor or handle.

In the example, the magnets are oriented at an angle (for the first pair **21, 23** of magnets) or (for the second pair **22, 24** of magnets) with respect to the frame. As in the example above the poles of the magnets can be rotated to switch between the first and second state and also reverse the direction of the magnetic field to provide a demagnetization of the surface.

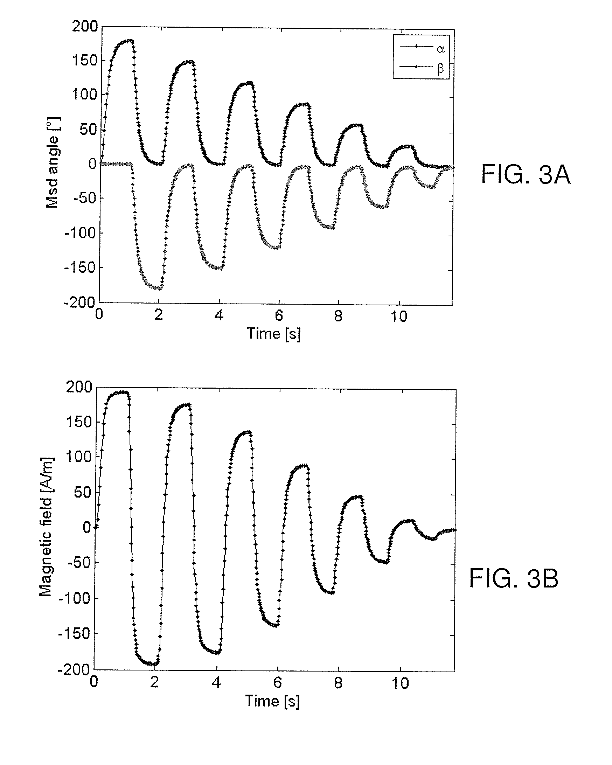

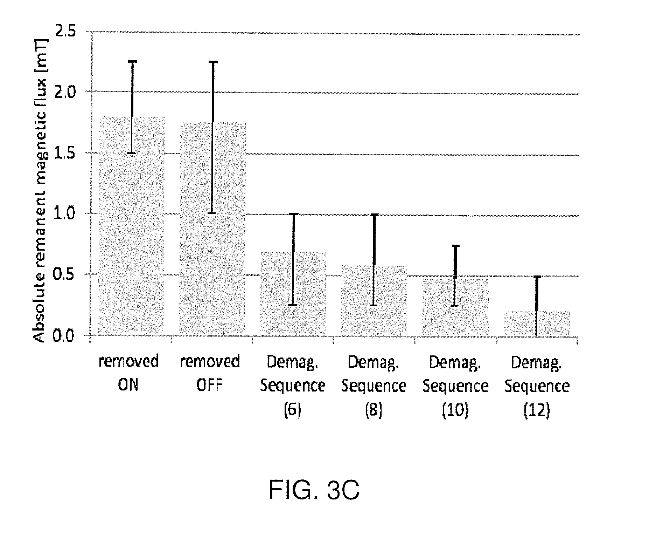

As shown in FIGs. 3, the angles and hence the relative orientation of the magnets determines the strength of the magnetic field and its direction in the inspected surface. The two branches of FIG. 3A show how the angles α and β can be varied for a demagnetization process. The resulting magnetic field strength in the sample is shown in the curve of FIG. 3B. A significant demagnetization of the sample can be already achieved within 6 cycles. The reduction in the remanent field strength after a given number of cycles is illustrated in FIG. 3C.

An inspection tool exemplifying the above principles is shown in FIG. 4. The frame structure described above is used as a chassis **40** to provide a small, light-weight and readily movable tool. The chassis and the elements mounted onto it are protected by a dome-shaped outer shell **41.** The outer shell **41** can be made of any nonmagnetic material such as plastics or non-magnetic metal.

The chassis **40** itself includes the iron frame with the magnets **42,** a central opening **401** and extensions **402** as described above. Further mounted onto the chassis **40** is a nozzle **43** through which magnetic particles can be sprayed. The nozzle is charged through a tube **431,** which in turn is connected to a remote reservoir of dry magnetic particles or a (wet) suspension of magnetic particles **432.** The particles **432** are preferably fluorescent. Such particles are known and commercially available for example under the tradename Magnaglo® 14 A.

In addition, the chassis carries the optics **44** of a camera system including a pair of UVA LEDs **441** which emit UV radiation causing fluorescence of the magnetic particles. The camera system includes further elements such as images sensor and image display units, which depending on size or energy consumption may or may not be installed as part of the apparatus. In the case of a remote image detection and display system, the link **442** between the optical components and the remote parts can be made using an optical fiber cable **442** as shown or wireless signal transmission.

The inspection tool is further shown to include three spherical wheels **45,** mounted such that the apparatus can be moved into arbitrary directions on the surface **46** to be inspected. A position encoder **47** detects the motion of the apparatus on the surface **46** and its output signal can be used to record the position of the apparatus and hence the location of any defects **461** of the surface detected by it. The manner in which the encoder is mounted and operates allows for the recording of a map of defect location in two or three dimensions.

In operation the inspection tool is positioned onto the surface **46** to be examined. This surface can be for example the blade of a steam turbine fixed to a turbine rotor within a power plant. As the apparatus is moved on the surface by hand or with a small motor, the magnetic particles **432** are sprayed onto the surface through the nozzle **43.** The cavity formed by the chassis around the nozzle **43** limits the spread of the magnetic particles beyond the part of the surface **46** immediately below the tool.

The magnets **42** are switched to provide a magnetic field **H** within the surface and are switched to either demagnetize the surface again or to move the tool along the surface.

The particles are illuminated using the pair of UVA LEDs **441** and when illuminated start to emit fluorescent light. The camera **44** provides a continuous monitoring of the surface **46** which is traversed by the apparatus and registers the spatial distribution of light emitted or reflected from the magnetic particles **432** thus representing their own spatial distribution. Through visual inspection or by using computer-based image processing the sequence of images can be evaluated for the presence of surface or near surface defects **461** in the material.

The position related information as measured by the position encoder **47** can be utilized to determine and display of the location of any defects detected.

The present invention has been described above purely by way of example, and modifications can be made within the scope of the invention, particularly as relating to the shape and design of the chassis and the arrangement of elements it carries. The invention also consists in any individual features described or implicit herein or shown or implicit in the drawings or any combination of any such features or any generalization of any such features or combination, which extends to equivalents thereof. Thus, the breadth and scope of the present invention should not be limited by any of the above-described exemplary embodiments.

Each feature disclosed in the specification, including the drawings, may be replaced by alternative features serving the same, equivalent or similar purposes, unless expressly stated otherwise.

Unless explicitly stated herein, any discussion of the prior art throughout the specification is not an admission that such prior art is widely known or forms part of the common general knowledge in the field.

### LIST OF REFERENCE SIGNS AND NUMERALS

frame **10, 20**
opening **101**
extensions **102**
surface **11**
magnets **12, 13, 21, 22, 23, 24**
angles α, β
chassis **40**
shell **41**
magnets **42**
opening **401**
extensions **402**
nozzle **43**
tube **431**
magnetic particles **432**
optics **44**
LEDs **441**
fiber cable **442**
wheels **45**
surface **46**
surface defects **461**
position encoder **47**
magnetic field **H**

## Claims

1. An apparatus for the inspection of ferromagnetic components using magnetic particles with the apparatus comprising a movable chassis defining a magnetic yoke with a central opening over a surface of the component to be inspected and a discharge nozzle to inject the magnetic particles onto the surface, a magnetic field source for generating a magnetic field on at least part of the surface below the opening and a probe to measure a representation of the spatial distribution of the magnetic particles on the surface.

2. The apparatus of claim 1 wherein the magnetic field source comprises a magnetic switchable device.

3. The apparatus of claim 2 wherein magnetic field source comprises at least two magnets located at positions separated by the central opening with at least one of the at least two magnets being rotatably mounted within the chassis defining the yoke.

4. The apparatus of claim 2 wherein magnetic field source comprises at least four paired magnets with the pairs located at positions separated by the central opening with each magnet being rotatably mounted within the chassis defining the yoke.

5. The apparatus of claim 1 wherein the yoke has a plane defined as the plane including the opening and includes out-of-plane extensions to reduce the distance to the surface.

6. The apparatus of claim 1 comprising support elements lifting the bottom of the apparatus off the surface and enabling rolling or gliding movement of the apparatus across the surface to be inspected.

7. The apparatus of claim 1 having a longest horizontal dimension of less than 200 mm and a height of less than 100 mm.

8. The apparatus of claim 1 having a weight of less than 5 kg.

9. The apparatus of claim 1 comprising a discharge opening connected to a reservoir of magnetic particles and designed to distribute the magnetic particles onto the surface of the component to be inspected.

10. The apparatus of claim 1 wherein the probe to measure a representation of spatial distribution includes an optical detector.

11. The apparatus of claim 1 wherein the probe to measure a representation of spatial distribution includes an optical detector and a source to illuminate the surface.

12. The apparatus of claim 1 comprising a sensor capable of measuring location information or derivatives of location information to determine an absolute or relative position of the apparatus on the surface.

13. A method for in-situ inspection of ferromagnetic components, the method including the steps of
- placing onto the airfoil an apparatus for the inspection of ferromagnetic components using magnetic particles with the apparatus comprising a movable chassis defining a magnetic yoke with a central opening over a surface of the component to be inspected and a discharge nozzle to inject the magnetic particles onto the surface, a magnetic field source for generating a magnetic field on at least part of the surface below the opening and a probe to measure a representation of the spatial distribution of the magnetic particles on the surface;
- generating a magnetic field on at least part of surface; and
- measuring a representation of the spatial distribution of the magnetic particles on the surface.

14. The method for in-situ inspection of airfoils of claim 13 further comprising the step of switching the magnetic field between a magnetizing and a non-magnetizing and/or de-magnetizing state.

15. The method for in-situ inspection of airfoils of claim 14 wherein the step of switching the magnetic field between a magnetizing and a non-magnetizing and/or de-magnetizing state includes the rotation of magnets mounted onto the chassis.
